# EUROPEAN PATENT SPECIFICATION

(11) **EP 4 503 379 B1**
(45) Date of publication and mention of the grant of the patent: **12.08.2026**
(21) Application number: 23827462.5
(22) Date of filing: 19.06.2023
(51) Int. Cl.: H02J 7/34, G01R 31/389, G01R 31/382, H02J 7/00, B60L 58/13, B60L 58/18, B60L 3/00, B60L 53/80, B60L 58/16

(54) **BATTERY SWAPPING SYSTEM AND OPERATION METHOD THEREFOR**
BATTERIEWECHSELSYSTEM UND BETRIEBSVERFAHREN DAFÜR
SYSTÈME DE PERMUTATION DE BATTERIE, ET SON PROCÉDÉ DE FONCTIONNEMENT

(30) Priority: 24.06.2022 KR 20220077855
(43) Date of publication of application: 05.02.2025
(73) Proprietor: LG Energy Solution, Ltd., Seoul 07335 (KR)
(72) Inventor: CHOI, Yean Sik, Daejeon 34122 (KR)
(74) Representative: Plasseraud IP
(86) International application number: PCT/KR2023/008437
(87) International publication number: WO 2023/249346

(56) References cited:
- CN-A- 113 815 473
- CN-A- 114 285 118
- CN-U- 216 331 544
- JP-A- 2015 100 169
- KR-A- 20140 064 098
- KR-A- 20160 143 092
- KR-A- 20200 001 696
- KR-A- 20210 101 136

## Description

### [TECHNICAL FIELD]

### CROSS-REFERENCE TO RELATED APPLICATION

This application claims priority to and the benefit of Korean Patent Application No. 10-2022-0077855 filed in the Korean Intellectual Property Office on June 24, 2022.

### TECHNICAL FIELD

Embodiments disclosed herein relate to a battery swapping system that provides a battery swapping service, and an operating method of the battery swapping system.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. A lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

To analyze a state of a battery and detect operating characteristics of the battery over time, electrochemical impedance spectroscopy may be used. The electrochemical impedance spectroscopy may quickly and accurately detect impedance which is a factor hindering electricity transmission when a chemical reaction occurs at an electrode included in the battery. The state of the battery may be quickly evaluated by detecting the impedance of the battery, and it is possible to inspect battery quality, predict the remaining life, and optimize a charging method corresponding to the state of the battery, based on the evaluation.

Meanwhile, with the increasing interest and demand for electric vehicles using large-capacity batteries such as electric vehicles, a service for automatically replacing an exhausted battery within a short period of time is attracting attention.

Examples of background art are provided in documents CN 216 331 544 U and CN 113 815 473 A.

### [DISCLOSURE]

### [TECHNICAL PROBLEM]

Embodiments disclosed herein aim to provide a battery swapping system capable of improving energy efficiency and an operating method of the battery swapping system.

Technical problems of the embodiments disclosed herein are not limited to the above-described technical problems, and other unmentioned technical problems would be clearly understood by one of ordinary skill in the art from the following description.

### [TECHNICAL SOLUTION]

A battery swapping system according to an embodiment of the present disclosure is defined in the appended claims.

### [ADVANTAGEOUS EFFECTS]

With a battery swapping system and an operating method thereof according to the present disclosure, without user's time and effort to consume a battery outside to match an SoC of a battery pack to a target SoC, a BSS autonomously set the SoC of the battery pack as the target SoC automatically, thereby providing a battery swapping service.

Moreover, when the SoC of the battery pack is greater than the target SoC, surplus power may be stored using a battery added in the BSS and may be preferentially used to charge the battery pack, without wasting the surplus power, thereby improving power efficiency.

Moreover, various effects recognized directly or indirectly from the disclosure may be provided.

### [DESCRIPTION OF DRAWINGS]

FIG. 1 is a block diagram of a battery management system according to an embodiment disclosed herein.
FIG. 2 is a view illustrating in detail a BSS and a battery station shown in FIG. 1.
FIG. 3 is a flowchart illustrating an example of an operating method of a BSS according to an embodiment of the present disclosure.
FIG. 4 is a flowchart illustrating in detail operation S180 shown in FIG. 3.
FIG. 5 is a block diagram showing a hardware configuration of a computing system for performing an operating method of a battery management system, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

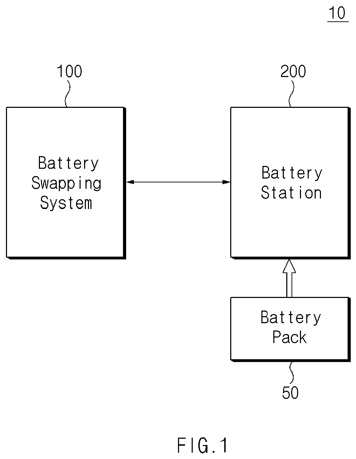

FIG. 1 is a block diagram of a battery management system according to an embodiment disclosed herein.

Referring to FIG. 1, a battery management system 10 according to an embodiment disclosed herein may include a battery swapping system (BSS) 100 and a battery station 200. The battery management system 10 may provide an overall management service for evaluation, measurement, charge, replacement, etc., of a battery, and in the present disclosure, a function of the battery management system 10 will be described based on a battery swapping service.

The battery swapping service may mean a service that analyzes a state of a battery pack 50 that is a service subject and replaces the battery pack 50 with another battery pack according to an analysis result. Such replacement may be automatically performed by a manager and/or user's setting. Herein, the battery pack 50 may be a device mounted on a subject device (e.g., an electrical transportation such as an electrical vehicle, an electrical scooter, an electrical bike, etc.) to supply power for driving the subject device, and may include a battery for storing power and a battery management system (BMS) for controlling an operation of the battery. The battery may include at least one battery cell for storing power under control of the BMS. The BMS may control charge and discharge of the battery, and collect data that is a basis for state analysis of the battery and transmit the data to an external device at the request of the external device.

The BSS 100 may be positioned in the battery station 200 to perform state analysis on the battery pack 50 connected to the BSS 100, and replace the battery pack 50 with another battery pack or reuse (i.e., may not replace) the battery pack 50 based on a result of the state analysis. The BSS 100 may autonomously determine whether state analysis and/or replacement of the battery pack 50 is required, but according to another embodiment, at least some operation may be performed in association with a server (e.g., a cloud server) connected through a network. For example, the BSS 100 may transmit to the cloud server, information (e.g., EIS information to be described) that is a basis for determining whether replacement of a battery pack is required, and the cloud server may transmit to the BSS 100, the information about whether replacement of the battery pack is required.

The battery station 200 may accommodate the battery pack 50 and physically control the battery pack 50 under control of the BSS 100. According to an embodiment, the battery station 200 may separate the battery pack 50 mounted on a subject device to connect the same to the BSS 100 under control of the BSS 100, and then mount another battery pack on the subject device in place of the battery pack 50, and move (i.e., replace) the battery pack 50 to a predefined storage area in the battery station 200 or mount (i.e., reuse) the battery pack 50 on the subject device again under control of the BSS 100. The storage region may be a region for temporarily storing the battery pack 50 classified as a replacement subject.

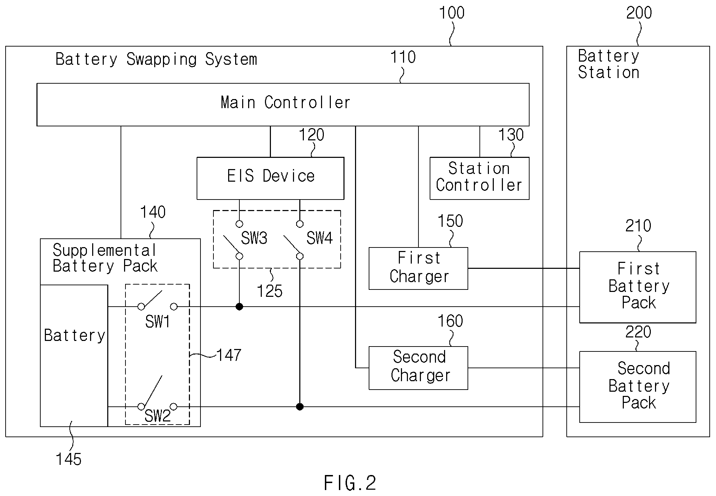

FIG. 2 is a view illustrating in detail the BSS 100 and the battery station 200 shown in FIG. 1.

Referring to FIG. 2, the BSS 100 may include a main controller 110, an electrochemical impedance spectroscopy (EIS) device 120, an EIS device connection unit 125, a station controller 130, a supplemental battery pack 140, a first charger 150, and a second charger 160. While it is shown in FIG. 2 that two battery packs 210 and 220 for receiving a battery swapping service are connected to the BSS 100, the scope of the present disclosure is not limited thereto and a random number of (e.g., three or more) battery packs for receiving the battery swapping service may be connected to the BSS 100. In this case, battery packs other than the battery packs 210 and 220 may be connected to the BSS 100 through a connection structure corresponding to the battery packs 210 and 220.

The main controller 110 may control an overall operation of the BSS 100, and specifically control an operation of each of the EIS device 120, the EIS device connection unit 125, the station controller 130, the supplemental battery pack 140, the first charger 150, and the second charger 160. The main controller 110 may receive state of charge (SoC) information of each of the first battery pack 210 and the second battery pack 220 connected to the BSS 100 from a corresponding battery pack. Herein, the SoC information may indicate a current SoC of the corresponding battery pack and the SoC may mean a charge state of a battery included in the battery pack, i.e., a remaining capacity rate. A BMS of the corresponding battery pack may calculate the remaining capacity rate by dividing the current available capacity of the battery by a total capacity of the battery. For example, the remaining capacity rate may be calculated as a percentage. According to another embodiment, the main controller 110 may obtain SoC information by directly calculating a remaining capacity rate for a battery of a battery pack without receiving the SoC information from a BMS of the battery pack.

The main controller 110 may perform state analysis on the battery packs 210 and 220 based on the EIS information generated by the EIS device 120, and determine whether replacement of the battery packs 210 and 220 is required based on a result of the state analysis. The EIS information may be information indicating a result of estimating a deterioration state and performance of a battery of the battery packs 210 and 220 by using EIS. For example, when the deterioration rate and performance of the battery of the battery packs 210 and 220 are less than a reference level as a result of the state analysis performed based on the EIS information, the main controller 110 may determine that replacement of the battery packs 210 and 220 is required. On the other hand, when the deterioration rate and performance of the battery of the battery packs 210 and 220 are greater than or equal to the reference level as a result of the state analysis performed based on the EIS information, the main controller 110 may determine that replacement of the battery packs 210 and 220 is not required. In the present disclosure, a description will be made of a scheme to determine whether replacement of the battery packs 210 and 220 is required based on the EIS information, but the scope of the present disclosure is not limited thereto and the main controller 110 may determine whether replacement of the battery packs 210 and 220 is required by further using at least one information (e.g., a state of health (SoH), etc.) in addition to the EIS information.

When replacement of the battery packs 210 and 220 is required, the main controller 110 may control the station controller 130 to move the battery packs 210 and 220 to the storage region and to mount a new battery pack on the subject device.

When replacement of the battery packs 210 and 220 is not required, the main controller 110 may control the station controller 130 to mount the battery packs 210 and 220 again on the subject device.

The EIS device 120 may measure an impedance of the battery of the battery packs 210 and 220, calculate an impedance spectrum of the battery based on the measured impedance, and compare the calculated impedance spectrum of the battery with an equivalent circuit of the battery to estimate the deterioration rate and performance of the battery, thus generating the EIS information. According to an embodiment, the scheme to measure the impedance of the battery may apply an input alternating current voltage while changing a frequency and analyze an output alternating current voltage received from the battery to calculate the impedance. Although it is shown in FIG. 2 that there is one signal line connected between the EIS device 120 and the battery packs 210 and 220, this may be a concept including a plurality of signal lines (an input power line, an output power line, a control signal line, etc.) for impedance measurement.

The EIS device 120 may also be referred to as an impedance measurement device. An operation of the EIS device 120 to generate the EIS information for the battery of the battery packs 210 and 220 may be defined as an EIS measurement operation.

The EIS device connection unit 125 may perform electric connection or separation between the EIS device 120 and the battery packs 210 and 220 under control of the main controller 110. According to an embodiment, the EIS device connection unit 125 may include a third switch SW3 connected between the EIS device 120 and the battery pack 210 to electrically connect or separate the EIS device 120 and the battery pack 210 to each other or from each other and a fourth switch SW4 connected between the EIS device 120 and the battery pack 220 to electrically connect or separate the EIS device 120 and the battery pack 220 to each other or from each other.

The station controller 130 may control the battery station 200 under control of the main controller 110 to control electric connection and separation of each of the battery packs 210 and 220 accommodated in the battery station 200 and movement between predefined regions in the battery station 200. For example, movement between the predefined regions may be controlled by opening or closing a gate installed between the predefined regions, and the station controller 130 may control movement of each of the battery packs 210 and 220 by controlling each of a plurality of gates of the battery station 200. The station controller 130 may perform physical control for replacement or reuse of each of the battery packs 210 and 220 according to a result of determining by the main controller 110 whether replacement of each of the battery packs 210 and 220 is required.

The supplemental battery system 140 may include a battery 145 and a battery connection unit 147. The supplemental battery pack 140 may include an internal component corresponding to each of the battery packs 210 and 220, and accordingly include a BMS (not shown) for controlling an operation of the battery 145. The battery connection unit 147 may be implemented as a part of the BMS, but may be a component independent of the BMS without the scope of the present disclosure being limited thereto.

The battery 145 may be connected to each of the battery packs 210 and 220 to receive and store power from each of the battery packs 210 and 220 for discharge of each of the battery packs 210 and 220, and to transmit the stored power to each of the battery packs 210 and 220 for charge of each of the battery packs 210 and 220. Charging and discharging operations of the battery 145 connected to each of the battery packs 210 and 220 may be performed to match an SoC of each of the battery packs 210 and 220 to a target SoC. That is, when the SoC of the battery pack is higher than a target SoC, power may be transmitted from the battery of the battery pack to the battery 145. When the SoC of the battery pack is lower than the target SoC, power may be transmitted from the battery 145 to the battery of the battery pack. The charge and discharge operations of the battery 145 may be dynamically controlled by the main controller 110 based on the SoC information of the battery 145.

Meanwhile, power of the battery 145 received and stored to discharge any one battery pack (e.g., 210) from the battery pack 210 may be transmitted to charge another battery (e.g., 220) to the battery pack 220.

In order for the EIS device 120 to obtain accurate EIS information for the battery pack, the battery pack may be required to have a specific target SoC. That is, the EIS information may vary depending on the SoC of the battery pack, such that in order for the EIS information to accurately indicate the deterioration state and performance of the battery, impedance measurement and EIS information generation for the battery pack need to be performed under a condition where the SoC of the battery pack is equal to a predefined target SoC. For example, the target SoC may be 50 %, but the scope of the present disclosure is not limited thereto.

The battery connection unit 147 may perform electric connection or separation between the battery 145 and the battery packs 210 and 220 under control of the main controller 110. According to an embodiment, the battery connection unit 147 may include a first switch SW1 connected between the battery 145 and the battery pack 210 to electrically connect or separate the battery 145 and the battery pack 210 to each other or from each other and a second switch SW2 connected between the battery 145 and the battery pack 220 to electrically connect or separate the battery 145 and the battery pack 220 to each other or from each other.

The first charger 150 may charge the first battery pack 210 under control of the main controller 110. The first charger 150 may receive power from an external commercial power source, convert the same into a power form that may be received by the first battery pack 210, and supply the power to the first battery pack 210. According to an embodiment, the first charger 150 may supply power until the SoC of the first battery pack 210 reaches 100 % so as to fully charge the first battery pack 210.

The second charger 160 may charge the second battery pack 220 under control of the main controller 110. The second charger 160 may receive power from an external commercial power source, convert the same into a power form that may be received by the second battery pack 220, and supply the power to the second battery pack 220. According to an embodiment, the second charger 160 may supply power until the SoC of the second battery pack 220 reaches 100 % so as to fully charge the second battery pack 220.

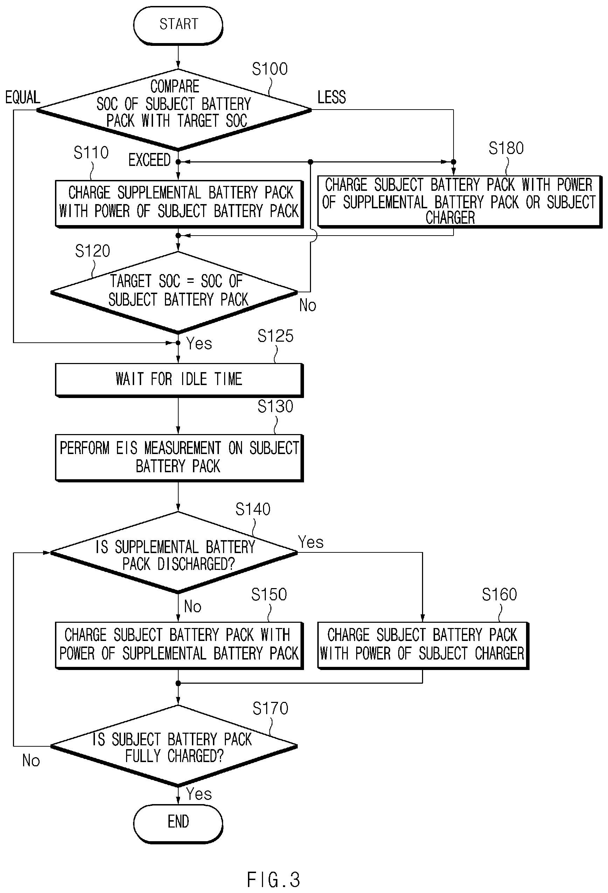

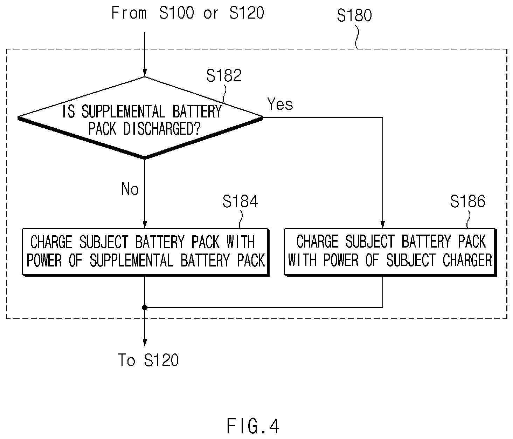

FIG. 3 is a flowchart illustrating an example of an operating method of the BSS 100 according to an embodiment of the present disclosure. FIG. 4 is a flowchart illustrating in detail operation S180 shown in FIG. 3.

FIGS. 3 and 4 show a flowchart of an operation of performing EIS measurement and charge on a subject battery pack before determining whether replacement or reuse of the subject battery pack is required. Herein, the subject battery pack may mean a battery pack that is a subject for a battery swapping service, and for example, the subject battery pack may correspond to the first battery pack 210 or the second battery pack 220 of FIG. 2.

The main controller 110 may obtain a subject SoC of a subject battery pack and compare the subject SoC of the subject battery pack with a target SoC, in operation S100.

When the subject SoC of the subject battery pack is equal to the target SoC (Equal in operation S100), operation S125 may be performed. Herein, "Equal" may be a concept including not only completely physical match, but also a case where the subject SoC of the subject battery pack falls within a specific range around the target SoC. Likewise, "Exceed" may mean a case of being greater than an upper limit over the target SOC by a predetermined value, and "Less" may mean a case of being less than a lower limit below the target SoC by a predetermined value. According to an embodiment, the specific range may a range greater than or equal to the lower limit and less than or equal to the upper limit.

When the subject SoC of the subject battery pack exceeds the target SoC (Exceed in operation S100), the main controller 110 may control the supplemental battery pack 140 to transmit power to the supplemental battery pack 140 from the subject battery pack, thus charging the supplemental battery pack 140. For example, when the subject battery pack is the first battery pack 210, the main controller 110 may short-circuit the first switch SW1 to charge the supplemental battery pack 140.

The main controller 110 may obtain the subject SoC of the subject battery pack again and determine whether the subject SoC of the subject battery pack is equal to the target SoC, in operation S120. According to an embodiment, operation S120 may be performed according to a predefined period.

When the subject SoC of the subject battery pack is not equal to the target SoC (No in operation S120), operations S110 and S120 may be repeatedly performed again.

When the subject SoC of the subject battery pack is equal to the target SoC (Yes in operation S100), the main controller 110 may control the supplemental battery pack 140 to electrically separate the subject battery pack from the supplemental battery pack 140 to block power transmission, thereby stopping charge of the supplemental battery pack 140. For example, when the subject battery pack is the first battery pack 210, the main controller 110 may open the first switch SW1.

When the subject SoC of the subject battery pack is equal to the target SoC, EIS measurement for the subject battery pack may not be immediately performed and may be performed after a power supply device (i.e., a supplemental battery pack or a subject charger) electrically connected to the subject battery pack is electrically separated from a subject battery pack and a preset idle time elapses, in operation S125.

When the main controller 110 identifies an elapse of the preset idle time from determining that the subject SoC is equal to the target SoC, the main controller 110 may control the EIS 120 to perform EIS measurement on the subject battery pack. For EIS measurement, the main controller 110 may control the EIS device connection unit 125 to electrically connect the EIS device 120 to the subject battery pack. For example, when the subject battery pack is the first battery pack 210, the main controller 110 may short-circuit the first switch SW1 to electrically connect the EIS device 120 to the first battery pack 210.

The EIS device 120 may generate EIS information by performing EIS measurement on the subject battery pack, in operation S130. The EIS device 120 may transmit the EIS information about the subject battery pack to the main controller 110, and the main controller 110 may perform state analysis based on the EIS information and evaluate a deterioration state and performance of a battery of the subject battery pack as a result of the state analysis to determine whether replacement of the subject battery pack is required. According to a result of the determination of whether replacement of the subject battery pack is required, the main controller 110 may perform an operation for replacing or reusing the subject battery pack through the station controller 130 after operation S170.

Meanwhile, upon completion of EIS measurement, the main controller 110 may control the EIS device connection unit 125 to electrically separate the EIS device 120 from the subject battery pack. For example, when the subject battery pack is the first battery pack 210, the main controller 110 may open the first switch SW1 to electrically separate the EIS device 120 to the first battery pack 210.

Thereafter, the main controller 110 may determine whether the supplemental battery pack 140 is discharged, in operation S140. While charge is performed on the supplemental battery pack 140 in operation S10, at least one battery pack as well as the subject battery pack may exist as a battery pack connectable to the supplemental battery pack 140 as described above, and power stored in the supplemental battery pack 140 may be transmitted to the at least one battery pack such that the supplemental battery pack 140 may be discharged as will be described later, requiring operation S140.

When the supplemental battery pack 140 is not discharged (No in operation S140), the main controller 110 may control the supplemental battery pack 140 to transmit power from the supplemental battery pack 140 to the subject battery pack, thus charging the subject battery pack, in operation S150. For example, when the subject battery pack is the first battery pack 210, the main controller 110 may short-circuit the first switch SW1 to charge the subject battery pack.

When the supplemental battery pack 140 is discharged (Yes in operation S140), the main controller 110 may control a charger (hereinafter, a subject charger) corresponding to the subject battery pack to transmit power from the subject charger to the subject battery pack, thus charging the subject battery pack, in operation S160. When operation S150 is performed before discharge of the supplemental battery pack 140, i.e., the supplemental battery pack 140 and the subject battery pack are electrically connected to each other, the main controller 110 may electrically separate the supplemental battery pack 140 from the subject battery pack before performing operation S160.

For example, when the subject battery pack is the first battery pack 210, the main controller 110 may control the first charger 150 to charge the subject battery pack.

The main controller 110 may obtain a subject SoC of the subject battery pack and determine whether the subject battery pack is fully charged, in operation S170. According to an embodiment, operation S170 may be performed according to a predefined period.

When the subject battery pack is fully charged (Yes in operation S170), the main controller 110 may control the supplemental battery pack 140 or the subject charger to stop currently performed charge and perform an operation of replacing or reusing the subject battery pack through the station controller 130.

When the subject battery pack is not fully charged (No in operation S170), operation S140 may be performed.

According to the foregoing operation, the main controller 110 may first charge the subject battery pack by transmitting power from the supplemental battery pack 140 to the subject battery pack, and when the supplemental battery pack 140 is discharged, the main controller 110 may charge the subject battery pack fully until the subject battery pack is fully charged, by transmitting power from the subject charger to the subject battery pack.

When the subject SoC of the subject battery pack is less than a target SoC (Less in operation S100), the main controller 110 may charge the subject battery pack by using power of the supplemental battery pack 140 or the subject charger, in operation S180.

In FIG. 4, operation S180 may include detailed operations S182, S184, and S186.

The main controller 110 may determine whether the supplemental battery pack 140 is discharged, in operation S182. While charge is not performed on the supplemental battery pack 140 before operation S182, at least one battery pack as well as the subject battery pack may exist as a battery pack connectable to the supplemental battery pack 140 as described above, and power may be transmitted from the at least one battery pack to the supplemental battery pack 140 such that the supplemental battery pack 140 may be charged as will be described later, requiring operation S182.

When the supplemental battery pack 140 is not discharged (No in operation S182), the main controller 110 may control the supplemental battery pack 140 to transmit power from the supplemental battery pack 140 to the subject battery pack, thus charging the subject battery pack, in operation S184. For example, when the subject battery pack is the first battery pack 210, the main controller 110 may short-circuit the first switch SW1 to charge the subject battery pack.

When the supplemental battery pack 140 is discharged (Yes in operation S182), the main controller 110 may control a subject charger corresponding to the subject battery pack to transmit power from the subject charger to the subject battery pack, thus charging the subject battery pack, in operation S186. When operation S184 is performed before discharge of the supplemental battery pack 140, i.e., the supplemental battery pack 140 and the subject battery pack are electrically connected to each other, the main controller 110 may electrically separate the supplemental battery pack 140 from the subject battery pack before performing operation S186.

For example, when the subject battery pack is the first battery pack 210, the main controller 110 may control the first charger 150 to charge the subject battery pack.

Thereafter, the main controller 110 may obtain the subject SoC of the subject battery pack again and determine whether the subject SoC of the subject battery pack is equal to the target SoC, in operation S120. According to an embodiment, operation S120 may be performed according to a predefined period.

When the subject SoC of the subject battery pack is not equal to the target SoC, operation S180 may be performed again, and operations S180 and S120 may be repeatedly performed until the subject SoC of the subject battery pack is equal to the target SoC.

According to the foregoing operation, in a situation where the subject SoC of the subject battery pack is less than the target SoC, the main controller 110 may first charge the subject battery pack by transmitting power from the supplemental battery pack 140 to the subject battery pack, and when the supplemental battery pack 140 is discharged, the main controller 110 may charge the subject battery pack fully until the subject SoC of the subject battery pack is equal to the target SoC, by transmitting power from the subject charger to the subject battery pack.

According to the present disclosure, without user's time and effort to consume the battery outside to match the SoC of the battery pack to the target SoC, the BSS 100 autonomously set the SoC of the battery pack as the target SoC automatically, thereby providing a battery swapping service.

Moreover, when the SoC of the battery pack is greater than the target SoC, surplus power may be stored using a battery added in the BSS 100 and may be preferentially used to charge the battery pack, without wasting the surplus power, thereby improving power efficiency.

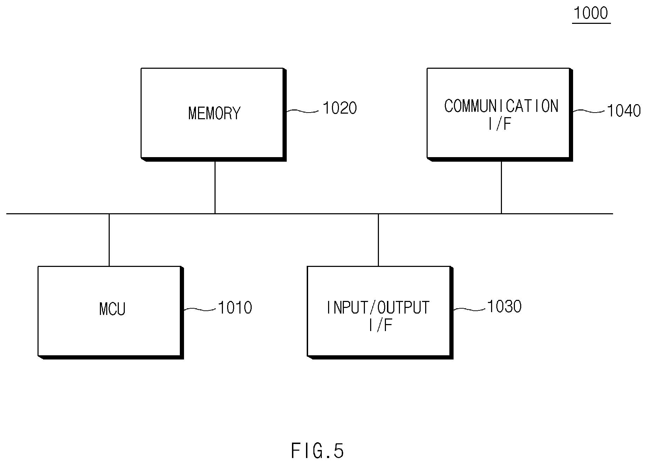

FIG. 5 is a block diagram showing a hardware configuration of a computing system for performing an operating method of a battery management system, according to an embodiment disclosed herein.

Referring to FIG. 5, a computing system 1000 according to an embodiment disclosed herein may include an MCU 1010, a memory 1020, an input/output I/F 1030, and a communication I/F 1040.

According to an embodiment, the computing system 1000 may be a system for performing the above-described operation of the battery management system 10 or the battery swapping system 100.

The MCU 1010 may be a processor that executes various programs stored in the memory 1020.

For example, the MCU 1010 may be a processor for processing data and/or a signal required for the main controller 110 to manage and control the battery management system 10.

The memory 1020 may store various programs and/or data required for managing and controlling the battery management system 10. The memory 1020 may be provided in plural, depending on a need.

The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from external components including a server, may be various devices capable of supporting wired or wireless communication.

As such, a computer program according to an embodiment disclosed herein may be recorded in the memory 1020 and executed and processed by the MCU 1010, thus being implemented as a module that performs functions shown in FIGS. 1 to 4.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

## Claims

1. A battery swapping system (100) comprising:
a main controller (110) configured to obtain a subject state of charge (SoC) of a subject battery pack (210; 220) and compare the subject SoC with a target SoC;
a supplemental battery pack (140) configured to receive and store power from the subject battery pack (210; 220) when the subject SoC exceeds the target SoC;
**characterized in that** it further comprises an impedance measurement device (120) configured to measure an impedance of the subject battery pack (210; 220) when the subject SoC is within a predefined range around the target SoC,
wherein the main controller (110) is further configured to control the impedance measurement device (120) to measure the impedance of the subject battery pack (210; 220) when an elapse of a predefined idle time is identified from when determining that the subject SoC is within a predefined range around the target SoC.

2. The battery swapping system of claim 1, wherein the supplemental battery pack (140) is further configured to transmit power to the subject battery pack (210; 220), when the subject SoC is less than the target SoC.

3. The battery swapping system of claim 2, further comprising a subject charger (150; 160) configured to charge the subject battery pack (210; 220) when the supplemental battery pack (140) is discharged.

4. The battery swapping system of claim 1, wherein the supplemental battery pack (140) is further configured to receive and store power from the supplemental battery pack (140) and then transmit the stored power to another battery pack.

5. The battery swapping system of claim 1, wherein the supplemental battery pack (140) is further configured to transmit power to the subject battery pack (210; 220), when measurement of an impedance of the subject battery pack (210; 220) is completed.

6. The battery swapping system of claim 5, further comprising a subject charger (150; 160) configured to charge the subject battery pack (210; 220) until the subject battery pack (210; 220) is fully charged, when the supplemental battery pack (140) is discharged.

7. The battery swapping system of claim 1, wherein the impedance measurement device (120) is further configured to generate electrochemical impedance spectroscopy (EIS) information indicating a result of estimating a deterioration state and performance of a battery included in the subject battery pack (210; 220) by using EIS based on the impedance measured for the subject battery pack (210; 220).

8. The battery swapping system of claim 7, wherein the main controller (110) is further configured to determine whether replacement of the subject battery pack (210; 220) is required, based on the EIS information.

9. The battery swapping system of claim 7, wherein the main controller (110) is further configured to transmit the EIS information to a cloud server and receive information about whether replacement of the subject battery pack (210; 220) is required, determined based on the EIS information.

10. The battery swapping system of claim 8, further comprising a station controller (130) configured to perform physical control for replacing or reusing the subject battery pack (210; 220) according to a result of determining whether replacement of the subject battery pack (210; 220) is required.

11. The battery swapping system of claim 1, wherein the supplemental battery pack (140) is electrically connectable to a plurality of battery packs comprising the subject battery pack (210; 220).

12. An operating method of a battery swapping system, the operating method comprising:
obtaining (S100) a subject state of charge (SoC) of a subject battery pack (210; 220);
comparing (S100) the subject SoC with a target SoC;
transmitting power (S110) from the subject battery pack (210; 220) to a supplemental battery pack (140) and storing the power in the supplemental battery pack (140), when the subject SoC exceeds the target SoC;
**characterized in** measuring (S130) an impedance of the subject battery pack (210; 220) when the subject SoC is within a predefined range around the target SoC;
wherein measuring (S130) the impedance of the subject battery pack (210; 220) is performed after elapse (S125) of a predefined idle time from when the subject SoC is within a predefined range around the target SoC.

13. The operating method of claim 12, wherein the subject battery pack (210; 220) is charged using power stored in the supplemental battery pack (140) preferentially to a subject charger (150; 160) corresponding to the subject battery pack (210; 220), when the subject SoC is less than the target SoC.

14. The operating method of claim 12, wherein the subject battery pack (210; 220) is charged using power stored in the supplemental battery pack (140) preferentially to a subject charger (150; 160) corresponding to the subject battery pack (210; 220), when measurement of the impedance of the subject battery pack (210; 220) is completed.

## Patentansprüche

1. Batteriewechselsystem (100), umfassend:
eine Hauptsteuerung (110), die konfiguriert ist, um einen betreffenden Ladezustand (SoC) eines betreffenden Batteriesatzes (210; 220) zu erhalten und den betreffenden SoC mit einem Soll-SoC zu vergleichen;
einen zusätzlichen Batteriesatz (140), der konfiguriert ist, um Strom von dem betreffenden Batteriesatz (210; 220) zu empfangen und zu speichern, wenn der betreffende SoC den Soll-SoC überschreitet;
**dadurch gekennzeichnet, dass** es ferner eine Impedanzmessvorrichtung (120) umfasst, die konfiguriert ist, um eine Impedanz des betreffenden Batteriesatzes (210; 220) zu messen, wenn der betreffende SoC innerhalb eines vordefinierten Bereichs um den Soll-SoC liegt,
wobei die Hauptsteuerung (110) ferner konfiguriert ist, um die Impedanzmessvorrichtung (120) zu steuern, um die Impedanz des betreffenden Batteriesatzes (210; 220) zu messen, wenn ein Ablauf einer vordefinierten Leerlaufzeit ab dem Zeitpunkt identifiziert wird, an dem bestimmt wird, dass der betreffende SoC innerhalb eines vordefinierten Bereichs um den Soll-SoC liegt.

2. Batteriewechselsystem nach Anspruch 1, wobei der zusätzliche Batteriesatz (140) ferner konfiguriert ist, um Strom an den betreffenden Batteriesatz (210; 220) zu übertragen, wenn der betreffende SoC kleiner als der Soll-SoC ist.

3. Batteriewechselsystem nach Anspruch 2, ferner umfassend ein betreffendes Ladegerät (150; 160), das konfiguriert ist, um den betreffenden Batteriesatz (210; 220) zu laden, wenn der zusätzliche Batteriesatz (140) entladen ist.

4. Batteriewechselsystem nach Anspruch 1, wobei der zusätzliche Batteriesatz (140) ferner konfiguriert ist, um Strom von dem zusätzlichen Batteriesatz (140) zu empfangen und zu speichern und dann den gespeicherten Strom an einen anderen Batteriesatz zu übertragen.

5. Batteriewechselsystem nach Anspruch 1, wobei der zusätzliche Batteriesatz (140) ferner konfiguriert ist, um Strom an den betreffenden Batteriesatz (210; 220) zu übertragen, wenn die Messung einer Impedanz des betreffenden Batteriesatzes (210; 220) abgeschlossen ist.

6. Batteriewechselsystem nach Anspruch 5, ferner umfassend ein betreffendes Ladegerät (150; 160), das konfiguriert ist, um den betreffenden Batteriesatz (210; 220) zu laden, bis der betreffende Batteriesatz (210; 220) vollständig geladen ist, wenn der zusätzliche Batteriesatz (140) entladen ist.

7. Batteriewechselsystem nach Anspruch 1, wobei die Impedanzmessvorrichtung (120) ferner konfiguriert ist, um Informationen der elektrochemischen Impedanzspektroskopie (EIS) zu erzeugen, die ein Ergebnis der Schätzung eines Verschlechterungszustands und einer Leistung einer in dem betreffenden Batteriesatz (210; 220) enthaltenen Batterie angeben, indem sie EIS auf der Grundlage der für den betreffenden Batteriesatz (210; 220) gemessenen Impedanz verwendet.

8. Batteriewechselsystem nach Anspruch 7, wobei die Hauptsteuerung (110) ferner konfiguriert ist, um auf der Grundlage der EIS-Informationen zu bestimmen, ob ein Austausch des betreffenden Batteriesatzes (210; 220) erforderlich ist.

9. Batteriewechselsystem nach Anspruch 7, wobei die Hauptsteuerung (110) ferner konfiguriert ist, um die EIS-Informationen an einen Cloud-Server zu übertragen und Informationen darüber zu empfangen, ob ein Austausch des betreffenden Batteriesatzes (210; 220) erforderlich ist, was auf der Grundlage der EIS-Informationen bestimmt wird.

10. Batteriewechselsystem nach Anspruch 8, ferner umfassend eine Stationssteuerung (130), die konfiguriert ist, um eine physische Steuerung zum Austauschen oder Wiederverwenden des betreffenden Batteriesatzes (210; 220) gemäß einem Ergebnis der Bestimmung durchzuführen, ob ein Austausch des betreffenden Batteriesatzes (210; 220) erforderlich ist.

11. Batteriewechselsystem nach Anspruch 1, wobei der zusätzliche Batteriesatz (140) elektrisch mit einer Vielzahl von Batteriesätzen verbindbar ist, die den betreffenden Batteriesatz (210; 220) umfassen.

12. Betriebsverfahren eines Batteriewechselsystems, wobei das Betriebsverfahren umfasst:
Erhalten (S100) eines betreffenden Ladezustands (SoC) eines betreffenden Batteriesatzes (210; 220);
Vergleichen (S100) des betreffenden SoC mit einem Soll-SoC;
Übertragen von Strom (S110) von dem betreffenden Batteriesatz (210; 220) an einen zusätzlichen Batteriesatz (140) und Speichern des Stroms in dem zusätzlichen Batteriesatz (140), wenn der betreffende SoC den Soll-SoC überschreitet;
**gekennzeichnet durch** Messen (S130) einer Impedanz des betreffenden Batteriesatzes (210; 220), wenn der betreffende SoC innerhalb eines vordefinierten Bereichs um den Soll-SoC liegt;
wobei das Messen (S130) der Impedanz des betreffenden Batteriesatzes (210; 220) nach Ablauf (S125) einer vordefinierten Leerlaufzeit ab dem Zeitpunkt durchgeführt wird, zu dem der betreffende SoC innerhalb eines vordefinierten Bereichs um den Soll-SoC liegt.

13. Betriebsverfahren nach Anspruch 12, wobei der betreffende Batteriesatz (210; 220) unter Verwendung von in dem zusätzlichen Batteriesatz (140) gespeichertem Strom vorzugsweise vor einem dem betreffenden Batteriesatz (210; 220) entsprechenden betreffenden Ladegerät (150; 160) geladen wird, wenn der betreffende SoC kleiner als der Soll-SoC ist.

14. Betriebsverfahren nach Anspruch 12, wobei der betreffende Batteriesatz (210; 220) unter Verwendung von in dem zusätzlichen Batteriesatz (140) gespeichertem Strom vorzugsweise vor einem dem betreffenden Batteriesatz (210; 220) entsprechenden betreffenden Ladegerät (150; 160) geladen wird, wenn die Messung der Impedanz des betreffenden Batteriesatzes (210; 220) abgeschlossen ist.

## Revendications

1. Système de permutation de batterie (100) comprenant :
un contrôleur principal (110) configuré pour obtenir un état de charge (SoC) objet d'un bloc-batterie objet (210 ; 220) et comparer le SoC objet à un SoC cible ;
un bloc-batterie supplémentaire (140) configuré pour recevoir et stocker de l'énergie provenant du bloc-batterie objet (210 ; 220) lorsque le SoC objet dépasse le SoC cible ;
**caractérisé en ce qu'**il comprend en outre un dispositif de mesure d'impédance (120) configuré pour mesurer une impédance du bloc-batterie objet (210 ; 220) lorsque le SoC objet se situe dans une plage prédéfinie autour du SoC cible,
dans lequel le contrôleur principal (110) est en outre configuré pour commander au dispositif de mesure d'impédance (120) de mesurer l'impédance du bloc-batterie objet (210 ; 220) lorsqu'un écoulement d'un temps de repos prédéfini est identifié à partir du moment où il est déterminé que le SoC objet se situe dans une plage prédéfinie autour du SoC cible.

2. Système de permutation de batterie selon la revendication 1, dans lequel le bloc-batterie supplémentaire (140) est en outre configuré pour transmettre de l'énergie au bloc-batterie objet (210 ; 220), lorsque le SoC objet est inférieur au SoC cible.

3. Système de permutation de batterie selon la revendication 2, comprenant en outre un chargeur objet (150 ; 160) configuré pour charger le bloc-batterie objet (210 ; 220) lorsque le bloc-batterie supplémentaire (140) est déchargé.

4. Système de permutation de batterie selon la revendication 1, dans lequel le bloc-batterie supplémentaire (140) est en outre configuré pour recevoir et stocker de l'énergie provenant du bloc-batterie supplémentaire (140) et ensuite transmettre l'énergie stockée à un autre bloc-batterie.

5. Système de permutation de batterie selon la revendication 1, dans lequel le bloc-batterie supplémentaire (140) est en outre configuré pour transmettre de l'énergie au bloc-batterie objet (210 ; 220), lorsque la mesure d'une impédance du bloc-batterie objet (210 ; 220) est terminée.

6. Système de permutation de batterie selon la revendication 5, comprenant en outre un chargeur objet (150 ; 160) configuré pour charger le bloc-batterie objet (210 ; 220) jusqu'à ce que le bloc-batterie objet (210 ; 220) soit complètement chargé, lorsque le bloc-batterie supplémentaire (140) est déchargé.

7. Système de permutation de batterie selon la revendication 1, dans lequel le dispositif de mesure d'impédance (120) est en outre configuré pour générer des informations de spectroscopie d'impédance électrochimique (EIS) indiquant un résultat de l'estimation d'un état de détérioration et d'une performance d'une batterie incluse dans le bloc-batterie objet (210 ; 220) en utilisant une EIS basée sur l'impédance mesurée pour le bloc-batterie objet (210 ; 220).

8. Système de permutation de batterie selon la revendication 7, dans lequel le contrôleur principal (110) est en outre configuré pour déterminer si le remplacement du bloc-batterie objet (210 ; 220) est requis, sur la base des informations EIS.

9. Système de permutation de batterie selon la revendication 7, dans lequel le contrôleur principal (110) est en outre configuré pour transmettre les informations EIS à un serveur en nuage et recevoir des informations indiquant si le remplacement du bloc-batterie objet (210 ; 220) est requis, déterminées sur la base des informations EIS.

10. Système de permutation de batterie selon la revendication 8, comprenant en outre un contrôleur de station (130) configuré pour effectuer une commande physique pour remplacer ou réutiliser le bloc-batterie objet (210 ; 220) selon un résultat de la détermination si le remplacement du bloc-batterie objet (210 ; 220) est requis.

11. Système de permutation de batterie selon la revendication 1, dans lequel le bloc-batterie supplémentaire (140) peut être connecté électriquement à une pluralité de blocs-batteries comprenant le bloc-batterie objet (210 ; 220).

12. Procédé de fonctionnement d'un système de permutation de batterie, le procédé de fonctionnement comprenant :
l'obtention (S100) d'un état de charge (SoC) objet d'un bloc-batterie objet (210 ; 220) ;
la comparaison (S100) du SoC objet avec un SoC cible ;
la transmission d'énergie (S110) depuis le bloc-batterie objet (210 ; 220) à un bloc-batterie supplémentaire (140) et le stockage de l'énergie dans le bloc-batterie supplémentaire (140), lorsque le SoC objet dépasse le SoC cible ;
**caractérisé par** la mesure (S130) d'une impédance du bloc-batterie objet (210 ; 220) lorsque le SoC objet se situe dans une plage prédéfinie autour du SoC cible ;
dans lequel la mesure (S130) de l'impédance du bloc-batterie objet (210 ; 220) est effectuée après l'écoulement (S125) d'un temps de repos prédéfini à partir du moment où le SoC objet se situe dans une plage prédéfinie autour du SoC cible.

13. Procédé de fonctionnement selon la revendication 12, dans lequel le bloc-batterie objet (210 ; 220) est chargé en utilisant l'énergie stockée dans le bloc-batterie supplémentaire (140) de préférence à un chargeur objet (150 ; 160) correspondant au bloc-batterie objet (210 ; 220), lorsque le SoC objet est inférieur au SoC cible.

14. Procédé de fonctionnement selon la revendication 12, dans lequel le bloc-batterie objet (210 ; 220) est chargé en utilisant l'énergie stockée dans le bloc-batterie supplémentaire (140) de préférence à un chargeur objet (150 ; 160) correspondant au bloc-batterie objet (210 ; 220), lorsque la mesure de l'impédance du bloc-batterie objet (210 ; 220) est terminée.
